Europäisches Patentamt

(19) European Patent Office

Office européen des brevets

(11) Veröffentlichungsnummer: **0 066 036**

A2

(12) # EUROPÄISCHE PATENTANMELDUNG

(21) Anmeldenummer: 82100295.3

(22) Anmeldetag: 16.01.82

(51) Int. Cl.³: **G 03 B 27/20**

(30) Priorität: 03.06.81 IT 2196681 U

(43) Veröffentlichungstag der Anmeldung:
08.12.82 Patentblatt 82/49

(84) Benannte Vertragsstaaten:
AT BE CH DE FR GB LI NL SE

(71) Anmelder: REPRO MASTER ELECTRONIC S.R.L.
Via Pacini, 50
I-20131 Milano(IT)

(72) Erfinder: Parrini, Carlo Giovanni
Viale S. Carlo, 30
Segrate (Milano)(IT)

(74) Vertreter: Jaumann, Paolo
Studio Consulenza Brevetti Jaumann Piazza Castello, 2
I-20121-Milano(IT)

(54) Verbesserung an graphischen Maschinen für Photolithographie, Reprographie, Siebdruck, Bromographie.

(57) Verbesserung an graphischen Maschinen für Photolithographie, Reprographie, Siebdruck, Bromographie, mit einer Glasplatte und einem Vakuumtisch, zwischen denen z.B. ein die wiederzugebende Zeichnung tragender Film und eine zu gravierende Platte gelegt werden, wobei mittels einer Vakuumpumpe die Luft zwischen den aufeinanderliegenden Platten abgesaugt wird, dadurch gekennzeichnet, dass die Unterseite der Glasplatte eine feine Rauung aufweist, durch deren Kanäle die Luft nach allen Seiten hin entweichen kann.

EP 0 066 036 A2

- 1 -

" Verbesserung an graphischen Maschinen für Pho=
tolithographie, Reprographie, Siebdruck, Bromo=
graphie "

In graphischen Maschinen für Photolithographie, Reprographie, Siebdruck, Bromographie wird von einer Glasplatte und einem Vakuumtisch Gebrauch gemacht, zwischen denen z.B. ein die wiederzuge= bende Zeichnung tragender Film und eine zu gra= vierende Platte gelegt wird. Mittels des an den Vakuumtisch angelegten Vakuums wird die Luft von den aufeinandergelegten Platten — Glasplatte - Film - zu gravierende Platte- abgesaugt, sodass diese luftfrei aufeinander liegen. In der Praxis kommt es jedoch vor, dass zwischen der Glasplatte und dem darunterliegenden Film kleine Luftblasen verbleiben, welche die sogg. Newton-Ringe bilden, die wiederum Gravierdefekte auf der zu gravieren= den Platte verursachen. In der Praxis versucht man, diese Newton-Ringe durch wiederholtes

- 2 -

Einschalten der Vakuumpumpe zu vermeiden, was aber nicht immer gelingt und jedenfalls einen grossen Zeitverlust bedeutet.

Vorliegende Erfindung hat es sich zur Aufgabe gemacht, den Defekt der sogg. Newton-Ringe in den oben aufgeführten graphischen Maschinen zu vermeiden und diese Aufgabe wird dadurch gelöst, dass die dem darunter liegenden Film zugewandte Seite der darüberliegenden Glasplatte eine feine Rauung, in der Grössenordnung von einigen Hundertsteln von mm, aufweist.

Es hat sich in der Praxis gezeigt, dass einerseits mit einer solchen Rauung der Glasplatte, bei Anlegen des Vakuums, eine sofortige totale Evakurierung der Luft zwischen der Glasplatte und dem Film erfolgt, da die Luft nach allen Seiten hin durch die feine Rauung gebildeten Kanäle total entweichen kann und sich keine sogg. Newton-Ringe bilden und dass andererseits überraschenderweise durch die feine Rauung der Glasplatte die Schärfe des zu gravierenden Bildes nicht beeinträchtigt wird.

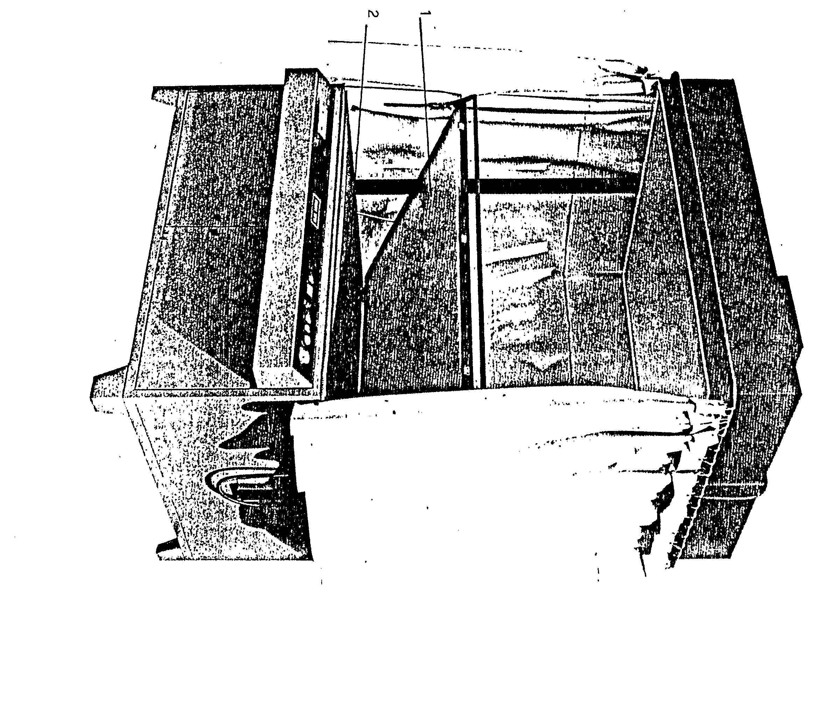

Die beiliegende Abbildung zeigt beispielsweise einen Bromographen mit der Glasplatte 1 und dem Vakuum-Tisch 2, unter dem sich eine Vakuumpumpe befindet. Auf den Tisch 2

- 3 -

wird die zu gravierende Platte und darauf der das
wiederzugebende Bild tragende Film gelegt. Darauf
wird die Glasplatte 1 abgesenkt, sodass Platten
und Film aufeinanderliegen und dann wird die Vakuum=
pumpe eingeschaltet, um die Luft zwischen den auf=
einanderliegenden Platten abzusagen. Das luftfreie
Anliegen der Glasplatte 1 auf dem darunterliegen=
den Film ist dadurch gewährleistet, dass infolge
der Rauung der Glasplatte 1, die Luft nach allen
Seiten hin entweichen kann und sich also keine
Newton-Ringe zwischen Glasplatte und Film bilden.

Die Rauung der Unterseite der Glaplatte 1 kann mit=
tels Sandstrahlung oder auf chemischem Wege erfol=
gen.

– 4 –

Patentansprüche

1.- Verbesserung an graphischen Maschinen für Photolithhographie, Reprographie, Sieb= druck, Bromographie, mit einer Glasplat= te (1) und einem Vakuumtisch (2), zwischen denen z.B. ein die wiederzugebende Zeich= nung tragender Film und eine zu gravieren= de Platte gelegt werden, wobei mittels einer Vakuumpumpe die Luft zwischen den aufeinanderliegenden Platten abgesaugt wird, dadurch gekennzeichnet, dass die Unterseite der Glasplatte (1) eine feine Rauung auf= weist, durch deren Kanäle die Luft nach al= len Seiten hin entweichen kann.

2.- Verbesserung nach Anspruch 1, dadurch gekenn= zeichnet, dass die Rauung der Unterseite der Glasplatte in der Grössenordnung von einigen Hundertsteln von mm ist.

1/1